# EUROPÄISCHE PATENTSCHRIFT

(11) **EP 1 387 189 B1**
(45) Veröffentlichungstag und Bekanntmachung des Hinweises auf die Patenterteilung: **05.03.2008**
(21) Anmeldenummer: 03017422.1
(22) Anmeldetag: 01.08.2003
(51) Int. Cl.: G02B 5/08, G03F 1/14

(54) **Mindestens zweischichtiges Substrat für die Mikrolithographie**
Substrate with at least two layers for microlithographic applications
Substrat à au moins deux couches pour applications microlithographiques

(30) Priorität: 02.08.2002 DE 10235731
(43) Veröffentlichungstag der Anmeldung: 04.02.2004
(73) Patentinhaber: Schott AG, 55122 Mainz (DE)
(72) Erfinder: Alkemper, Jochen, Dr., 55270 Klein-Winternheim (DE); Aschke, Lutz, Dr., 55129 Mainz (DE); Hack, Hrabanus, Dr., 55126 Mainz (DE)

(56) Entgegenhaltungen:
- EP-A- 1 095 379
- DE-A- 1 902 432
- DE-A- 10 127 086
- US-A- 4 865 451
- US-A- 6 159 643
- US-B1- 6 352 803
- US-B1- 6 387 572

## Beschreibung

Die vorliegende Erfindung betrifft ein Substrat für Präzisionselemente, wie beispielsweise Spiegel und Masken für die EUV-Mikrolithographie, die Herstellung eines derartigen Substrats, die Verwendung eines solchen Substrats, sowie ein solches Substrat umfassende Spiegel und/oder Masken bzw. Mask-Blanks für insbesondere die EUV-Mikrolithographie.

Bei der Herstellung integrierter Schaltkreise geht die Tendenz zu immer kleiner werdenden Strukturen auf den Chips. Um derartige Chips herzustellen, werden daher Lithograhie-Systeme erforderlich, welche mit zunehmend kleineren Belichtungswellenlängen arbeiten können. Derzeit werden Wellenlängen von 248, 193 bzw. 157 nm verwendet bzw. sind in der Entwicklung. Für die Zukunft ist für solche Lithographie-Systeme die Anwendung von elektromagnetischer Strahlung im sogenannten extremen UV-Bereich, insbesondere im Bereich von 11 bis 14 nm, vorgeschlagen worden. In diesem Wellenlängenbereich wird man von einem bisher üblichen Transmissionssystem auf ein Reflexionssystem mit reflektierenden optischen Elementen und Masken übergehen. Bisher sind für derartige reflektierende Systeme nur wenige Substrate für Masken und auch Spiegel für die dazugehörige Optik beschrieben worden, welche den extremen Anforderungen dieser Technik genügen.

DE 198 30 449 A1 beschreibt ein Spiegelsubstrat, bei welchem auf einem Substratkörper mit hoher thermischer Leitfähigkeit, insbesondere Silizium, eine dünne amorphe Schicht aus Quarzglas, amorphem Siliziumdioxid oder Aluminiumoxid aufgebracht wird.

US 6,159,643 beschreibt eine Reflexionsmaske, umfassend eine musterbildende Schicht und ein Substrat, wobei das Substrat eine Oberflächenschicht mit einer optischen Flachheit von dem Viertel einer Wellenlänge oder besser aufweist, und einer Unterschicht mit einem thermischen Ausdehnungskoeffizienten α (bzw. CTE) von weniger als 1,0 ppm/°C. Insbesondere wird als Deckschicht Silizium verwendet.

Diese beiden Schriften beschreiben die Verwendung von Silizium als eine der Schichten in einem Substrat für die EUV-Lithographie. Silizium weist jedoch eine hohe thermische Leitfähigkeit und eine hohe Wärmeausdehnung auf, was für die EUV-Lithographie nachteilig ist.

WO 01/07967 A1 und WO 01/08163 A1 beschreiben Masken beziehungsweise Spiegel für die EUV-Lithographie, wobei als Substrat titandotiertes hochreines Siliziumdioxidglas dient. Diese Materialien haben jedoch aufgrund ihres spezifischen Herstellungsprozesses in der Regel eine für eine Anwendung in der EUV-Lithographie unzureichende Homogenität.

US-B-6387571 betrifft ein zweischichtiges Substrat für die EUV-Lithographie das als eine erste Schicht ein Material mit einer geringen Wärmeausdehnung umfasst, worauf eine zweite Schicht aufgetragen ist, welche vorzugsweise Silizium, Saphir, Germanium, Beryllium oder Siliziumcarbid umfasst.

US-B-6453005 betrifft ein zweischichtiges Substrat für die EUV-Lithographie, das als erste Schicht monokristallines Silizium umfasst und als zweite Schicht Quarzglas, SiO₂ oder Aluminiumoxid umfasst.

Aschke et al. "Flatness Correction of NZTE Mask Blank Substrates", Proc. of the Spie, Vol. 4343, Seiten 646-453, beschreiben einschichtige EUV-Lithographiesubstrate, welche aus Materialien mit einer thermischen Ausdehnung nahe Null hergestellt wurden.

Glaskeramiken wie Zerodur^{®} eignen sich aufgrund ihrer extrem geringen Wärmeausdehnung und sehr guten Homogenität für die Anwendung als Masken und/oder Spiegel für die EUV-Lithographie.

Aus diesem Grunde wurden erste optische Systeme auf der Basis von Zerodur®-Substraten hergestellt. Dabei wurde festgestellt, dass diese zwar mit herkömmlichen Methoden auf eine spezifikationsgerechte Oberflächenrauhigkeit von 0,1 nm rms poliert werden können, diese Rauhigkeit jedoch beim anschließend üblichen lonenstrahlätzen verloren geht. Die Oberflächenrauhigkeit erhöht sich nach dieser Behandlung um einen Faktor 2 bis 5. Da jedoch Oberflächenrauhigkeiten von 0,1 nm rms für Substrate für die EUV-Lithographie erforderlich sind, ist der Einsatz derartiger Substrate für produktionstaugliche optische Systeme eingeschränkt.

Somit bestand die Aufgabe der vorliegenden Erfindung in der Bereitstellung neuartiger Substrate für Spiegel und/oder Masken, welche in der EUV-Lithographie verwendet werden können und welche die Nachteile des Stands der Technik nicht aufweisen.

Die vorstehende Aufgabe wird durch die in den Ansprüchen beschriebenen Ausführungsformen der vorliegenden Erfindung gelöst.

Insbesondere betrifft die vorliegende Erfindung ein Substrat für Präzisionselemente, umfassend mindestens eine Basisschicht und mindestens eine Deckschicht, wobei die Basisschicht einen thermischen Ausdehnungskoeffizienten von höchstens 10ppb/°C aufweist dadurch gekennzeichnet, dass die Deckschicht einen thermischen Ausdehnungskoeffizienten von höchstens 1 ppm/°C aufweist und die Deckschicht SiO₂, welches mit TiO₂ dotiert ist, umfasst.

Ein solches Substrat kann insbesondere als Substrat für optische Elemente, wie Masken oder Spiegel für die EUV-Mikrolithographie (EUV "Extreme Ultraviolet") Anwendung finden. Jedoch eignet sich das erfindungsgemäße Substrat auch für weitere Präzisionselemente, wie optische Elemente und Bauteile für Präzisionsanwendungen, welche eine geringe Wärmeausdehnung insbesondere in Kombination mit einer geringen Oberflächenrauhigkeit, wie höchstens 1 nm rms, mehr bevorzugt höchstens 0,5 nm rms, noch bevorzugter höchstens 0,2 nm rms, am meisten bevorzugt höchstens 0,1 nm rms erfordern.

Die Figuren zeigen:
Figur 1 zeigt eine Ausführungsform eines Spiegels unter Verwendung eines erfindungsgemäßen Substrats.
Figur 2 zeigt eine Ausführungsform eines Mask-Blanks für die EUV-Lithographie unter Verwendung eines erfindungsgemäßen Substrats.
Figur 3 zeigt eine Ausführungsform einer strukturierten Maske für die EUV-Lithographie unter Verwendung eines erfindungsgemäßen Substrats.

Gemäß der Erfindung umfasst der Bereich des "extremen UV" insbesondere elektromagnetische Strahlung mit einer Wellenlänge im Bereich von 11 bis 14 nm.

Es wurde beobachtet, dass der vorstehend beschriebene Nachteil von Materialien wie Glaskeramiken bzw. Keramiken überraschenderweise durch das Aufbringen einer Deckschicht mit geringer thermischer Ausdehnung, umfassend Siliziumdioxid, auf eine Unterschicht, umfassend ein Material mit einer sehr geringen Wärmeausdehnung, wie eine Glaskeramik, behoben werden kann. Insbesondere kann diese Basisschicht eine schlechtere Oberflächenrauhigkeit aufweisen, und es ist trotzdem möglich; die für beispielsweise die Mikrolithographie erforderliche Oberflächenrauhigkeit durch die Deckschicht einzustellen.

Das erfindungsgemäße Substrat weist somit mindestens eine zweischichtige Struktur auf, wobei mindestens eine sogenannte Basisschicht und mindestens eine sogenannte Deckschicht vorliegen.

Das erfindungsgemäße Substrat, bestehend aus mindestens einer Basisschicht und mindestens einer Deckschicht, hat eine geringe Wärmeausdehnung (CTE ≤ 1 ppm/°C) im Gegensatz zu einem Metall oder Halbmetall, wie beispielsweise Silizium (CTE > 2 ppm/°C), als Substratmaterial.

Besonders bevorzugt weist die Basisschicht oder die Basisschichten eine sogenannte Nahe-Null-Ausdehnung, wie nachstehend definiert, auf. Auch die Deckschicht(en) und/oder vorzugsweise auch ggf. vorhandene weitere Schichten weisen eine geringe Wärmeausdehnung von ≤ 1,0 ppm/°C, vorzugsweise ≤ 0,5 ppm/°C, auf.

Unter einer Basisschicht bzw. unteren Schicht wird bzw. werden diejenige Schicht bzw. diejenigen Schichten des Substrats verstanden, welche der späteren funktionellen Oberfläche des Präzisionselements, beispielsweise der reflektierenden Oberfläche einer Maske oder eines Spiegels für die EUV-Lithographie, abgewandt ist/sind.

Erfindungsgemäß umfasst die mindestens eine Basisschicht ein Material mit einem sehr geringen thermischen Ausdehnungskoeffizienten α (bzw. CTE). Diese Schicht bzw. das Material dieser Schicht weist einen thermischen Ausdehnungskoeffizienten von höchstens 10 ppb/°C auf. Besonders bevorzugt handelt es sich um ein sogenanntes "Nahe-Null-Ausdehnungsmaterial", welches in einem Temperaturbereich von -40°C bis +400°C, vorzugsweise in einem Temperaturbereich von 0° bis 50 °C, im wesentlichen keine Dimensionsänderung erfährt, d.h. einen CTE von höchstens 10 ppb/°C aufweist.

Vorzugsweise umfasst die Basisschicht des erfindungsgemäßen Substrats eine Keramik und/oder Glaskeramik. Als Glaskeramiken können beispielsweise die im Handel erhältlichen Produkte Zerodur® (SCHOTT Glas), Zerodur® M (SCHOTT Glas), Clearceram® (Ohara), Clearceram® Z (Ohara) oder andere Glaskeramiken mit geringer Wärmeausdehnung genannt werden. Als Keramiken sind solche mit einem thermischen Ausdehnungskoeffizienten ≤ 10 ppb/°C wie z.B. cordierithaltige Keramiken, aber auch Verbundwerkstoffe und Werkstoffverbunde (z.B. faserverstärkte Materialien mit geringer thermischer Ausdehnung) geeignet. Auch SiC, Aluminiumoxid und/oder Gemische davon können als Substratmaterial dienen.

Glaskeramiken sind anorganische, nicht poröse Materialien mit einer kristallinen Phase und einer glasigen Phase.

Clearceram^{®} und seine Varianten sind beispielsweise in US 5,591,682 beschrieben.

Erfindungsgemäß sind als Basisschicht Zerodur^{®} und dessen Varianten (z.B. Zerodur^{®} M) bevorzugt.

Zerodur^{®} wurde erstmals in DE 19 02 432 beschrieben. Bei Zerodur M^{®} handelt es sich um eine im wesentlichen Magnesiumoxid-freie Zerodur^{®}-Zusammensetzung, welche beispielsweise in US 4,851,372 beschrieben ist. Eigenschaften und Zusammensetzung von Zerodur^{®} und Zerodur^{®} M sind im Stand der Technik bekannt und beispielsweise in "Low Thermal Expansion Glass Ceramics", H. Bach (Herausgeber), Schott Series on Glass and Glass Ceramics, Sience, Technology, and Applications, Springer Verlag, beschrieben worden.

Zerodur^{®} enthält 70 bis 80 Gewichtsprozent Kristallphase bzw. kristalline Phase mit der sogenannten "Hoch-Quarz"-Struktur. Diese weist eine negative lineare Wärmeausdehnung auf, während die der glasigen Phase bzw. der Glasphase positiv ist. Die besondere Zusammensetzung des Basisglases der Glaskeramik Zerodur® und definierte Kristallkeimbildung und Kristallisationsbedingungen resultieren in einem Material mit extrem geringer Wärmeausdehnung, welche in bestimmten Temperaturbereichen Null oder leicht negativ sein kann.

Die Dicke der Basisschicht beträgt vorzugsweise mindestens 5 mm, so dass deren physikalische Eigenschaften, insbesondere deren Wärmeausdehnung, die des Gesamtsystems aus Basis- und Deckschicht bestimmten. Die Oberflächenrauhigkeit der Basisschicht vor Auftrag der Deckschicht beträgt vorzugsweise höchstens 1 nm rms, mehr bevorzugt höchstens 0,5 nm rms, noch bevorzugter 0,2 nm rms, am meisten bevorzugt 0,1 nm rms.

Die Basisschicht des erfindungsgemäßen Substrats kann auch aus mehreren Einzelschichten bestehen, wobei solche Ausführungsformen der vorliegenden Erfindung nicht bevorzugt sind. Solche Einzelschichten können eine unterschiedliche Zusammensetzung und/oder unterschiedliche physikalische Eigenschaften aufweisen, solange dies nicht den beschriebenen Eigenschaften der Basisschicht widerspricht.

Erfindungsgemäß ist über der Basisschicht bzw. den Basisschichten mindestens eine Deckschicht angeordnet, so dass sich ein mindestens zweischichtiges Substrat für beispielsweise die EUV-Lithographie ergibt.

Die Deckschicht kann aus mehreren Einzelschichten mit ggf. unterschiedlicher Zusammensetzung und/oder unterschiedlichen physikalischen Eigenschaften aufgebaut sein. Beispielsweise kann sich die Dotierung der Deckschicht auf der Seite, welche nahe der Basisschicht liegt, im Vergleich zu der der Basisschicht abgewandten Seite sprungartig oder auch graduell verändern. Sofern im folgenden der Begriff Deckschicht verwendet wird, ist die gesamte, ggf. aus mehreren Einzelschichten zusammengesetzte Deckschicht gemeint.

Die Deckschicht bzw. das Material der Deckschicht weist einen thermischen Ausdehnungskoeffizienten von höchstens 1,0 ppm/°C, vorzugsweise höchstens 0,5 ppm/°C, auf.

Die Deckschicht weist eine Stärke bzw. Dicke von mindestens 0,01 µm, bevorzugt mindestens 0,1 µm, und höchstens 100 µm, bevorzugt höchstens 50 µm, am meisten bevorzugt höchstens 10 µm, auf. Ferner weist diese Deckschicht vorzugsweise eine Oberflächenrauhigkeit von höchstens 0,5 nm rms, mehr bevorzugt von höchstens 0,2 nm rms und am meisten bevorzugt von höchstens 0,1 nm rms, auf.

Die Deckschicht umfasst Siliziumdioxid, wobei dieses mit Titanoxid und gegebenenfalls mit anderen Metalloxiden und/oder Fluor, sowie Gemischen dieser Komponenten dotiert ist. Mittels einer Dotierung mit Titanoxid kann der Wärmeausdehnungskoeffizient einer Siliziumdioxiddeckschicht an den Wärmeausdehnungskoeffizienten der Basisschicht angepasst werden. Vorzugsweise ist eine Siliziumdioxiddeckschicht mit einem Gehalt von 5 bis 10 Gew.-% Titanoxid dotiert.

Das erfindungsgemäße Substrat kann zwischen der Basisschicht und der Deckschicht gegebenenfalls eine Haftschicht umfassen. Mehr bevorzugt wird jedoch die Deckschicht direkt auf die Basisschicht aufgebracht. Es wurde gefunden, dass wahrscheinlich aufgrund der geringen Dicke der Deckschicht und der nur geringfügig unterschiedlichen Wärmeausdehnungskoeffizienten von Deckschicht und Basisschicht die Deckschicht auch bei Temperaturänderung keine Risse entwickelt, sondern auch nach Aufwärm- und Abkühlzyklen unzerstört und fest auf der Basisschicht haften bleibt.

Gemäß einer bevorzugten Ausführungsform bedeckt die Deckschicht die Oberfläche der Basisschicht vollständig. Es ist jedoch erfindungsgemäß möglich, dass die Deckschicht beispielsweise einen Randbereich der Basisschicht nicht bedeckt.

Die der Basisschicht abgewandet Oberfläche der Deckschicht des erfindungsgemäßen Substrats stellt die Oberfläche des Substrats dar, auf welche funktionelle Schichten, wie beispielsweise elektromagnetische Strahlung absorbierende, reflektierende oder verändernde Schichten aufgetragen werden können. Durch solche funktionellen Schichten wird das erfindungsgemäße Substrat in ein Präzisionselement, wie ein optisches Element oder Bauteil für Präzisionsanwendungen, umgewandelt. Solche funktionellen Schichten sind keine Bestandteile des erfindungsgemäßen Substrats.

Die vorliegende Erfindung betrifft ferner die Herstellung des erfindungsgemäßen Substrats, umfassend die Schritte
(a) Bereitstellen einer Basisschicht, welche einen thermischen Ausdehnungskoeffizienten von höchstens 10 ppb/°C aufweist,
(b) Aufbringen einer Deckschicht, welche einen thermischen Ausdehnungskoeffizienten von höchstens 1,0 ppm/°C aufweist, und
(c) gegebenenfalls Polieren der Deckschicht.

Vorzugsweise wird die bereitgestellte Basisschicht auf eine Rauhigkeit von höchstens 1 nm rms, vorzugsweise höchstens 0,5 nm rms, mehr bevorzugt höchstens 0,2 nm rms, am meisten bevorzugt höchstens 0,1 nm rms poliert.

Die Deckschicht wird auf diese Basisschicht vorzugsweise durch ein CVD-Verfahren (CVD "Chemical Vapour Deposition"), wie insbesondere ein PICVD-Verfahren (PICVD Plasma Impulse CVD"), PACVD-Verfahren (PACVD "Plasma Assisted CVD") oder PECVD-Verfahren (PECVD "Plasma Enhanced CVD") aufgebracht. Es können jedoch auch andere im Stand der Technik bekannte Verfahren wie beispielsweise ein Sol-Gel-Verfahren, ein PVD-Verfahren (PVD "Physical Vapour Deposition") und/oder Sputtern, ggf. unterstützt durch lonenbeschuß, verwendet werden.

Bei einem CVD-Verfahren werden durch Umsetzen von anorganischen oder organischen Vorläufermaterialien und Niederschlagen der Reaktionsprodukte auf eine Oberfläche Beschichtungen auf der Oberfläche hergestellt.

Bei einem PECVD-Verfahren werden sich in einer Gasphase, einem sogenannten "Plasma", befindliche organische oder anorganische Vorläufer der zu bildenden Schicht durch eine Glimmentladung aktiviert. Die Reaktionsprodukte schlagen sich dann als dünne Schicht auf der zu beschichtenden Oberfläche nieder. So hergestellte Schichten weisen eine hohe Packungsdichte (> 98%) auf und sind sehr stabil gegenüber Umgebungseinflüssen.

Bei einem PICVD-Verfahren werden Vorläufermaterialien des zu bildenden dielektrischen Materials in gasförmigen Zustand zusammen mit Sauerstoff und ggf. einem Trägergas, direkt in eine Mikrowellenentladungskammer gebracht und dieses Gemisch, d.h. das Plasma, durch eine Mikrowellenentladung gezündet. Die Schritte Einlassen des Plasmas in die Beschichtungskammer und Zünden durch einen Mikrowellenimpuls werden mehrfach durchgeführt, so dass sich ein "gepulster" Verfahrensablauf ergibt. Dieses Verfahren zeichnet sich durch hohe Abscheideraten (typischerweise 5 bis 15 nm/s) und gute Homogenität (beispielsweise eine Abweichung ≤ 1,5% über einen Radius von ca. 90 mm) aus.

Bei Sputterverfahren können als Sputtertarget neben Reinstoffen (Elemente und einfache Verbindungen) auch Gläser, Glaskeramiken und Keramiken dienen. Auf diese Weise können auch komplexe Zusammensetzungen als Deckschicht realisiert werden.

Es wird eine Deckschicht aufgebracht, welche mit TiO₂ dotiertes Siliziumdioxid umfasst. Eine derartige Deckschicht kann gegebenenfalls mit einem oder mehreren der vorstehend genannten weiteren Dotiermitteln dotiert sein. Diese Dotierung kann dazu verwendet werden, den thermischen Ausdehnungskoeffizienten der Deckschicht dem der Basisschicht anzupassen. In der Regel wird ein solches Anpassen nicht erforderlich sein, da beispielsweise Quarzglas bereits einen relativ geringen Wärmeausdehnungskoeffizienten aufweist und ferner die Deckschicht gemäß bevorzugter Ausführungsformen absolut und/oder im Vergleich zur Basisschicht relativ dünn ist.

Die Deckschicht wird in einer Stärke bzw. Dicke von mindestens 0,01 µm, bevorzugt mindestens 0,1 µm, und höchstens 100 µm, bevorzugt höchstens 50 µm, am meisten bevorzugt höchstens 10 µm, aufgebracht. Sofern ein Polieren der Deckschicht erforderlich ist und dadurch ein Teil der Deckschicht durch den Poliervorgang abgetragen wird, wird eine Schichtdicke aufgetragen, welche der Summe aus gewünschter Dicke der Deckschicht und der Dicke der durch das Polieren abgetragenen Schicht entspricht.

Nach dem Aufbringen der Deckschicht kann diese gegebenenfalls poliert werden. Gemäß bevorzugter Ausführungsformen weist die Deckschicht jedoch bereits durch den Auftragungsprozess die erforderliche Oberflächenrauhigkeit von höchstens 0,5 nm rms, mehr bevorzugt höchstens 0,2 nm rms, besonders bevorzugt höchstens 0,1 nm rms, auf. Sofern die Oberflächenrauhigkeit dieser Deckschicht noch oberhalb des erforderlichen Wertes liegt, wird die Schicht vorzugsweise poliert.

Die Deckschicht kann gegebenenfalls durch ein lonenstrahlverfahren (sogenanntes "Ion Beam Figuring (IBF)") oder auch durch magnetorheologisches Polieren nachbearbeitet werden.

Beim IBF-Verfahren wird ein lonenstrahl als Werkzeug zum Entfernen einer gewünschten Dicke von Material auf einer Oberfläche verwendet. Da die Ätzrate des lonenstrahls gering ist (typischer Weise 100 nm/min) ist dieses Verfahren nur zum Entfernen einer geringen Dicke von Material (max. einige µm) geeignet Beim "Ion Beam Figuring" werden quasi einzelne Atomlagen durch lonenbeschuss entfernt.

Die vorliegende Erfindung betrifft ferner die Verwendung des erfindungsgemäßen Substrats als ein Substrat für Präzisionselemente, wie optische Elemente und Bauteile für Präzisionsanwendungen. Vorzugsweise wird das erfindungsgemäße Substrat als Substrat für optische Elemente für die EUV-Lithographie verwendet, wie beispielsweise Masken, Mask-Blanks bzw. Maskenrohlinge und/oder Spiegel. Eine weitere bevorzugte Verwendung des erfindungsgemäßen Substrats ist die Verwendung als Spiegelsubstrat für Präzisionsspiegel, wie beispielsweise in der Astronomie oder der Messtechnik.

Optische Elemente für die EUV-Mikrolithographie umfassen neben dem erfindungsgemäßen Substrat auf der Oberfläche des Substrats eine EUV-Strahlung reflektierende Schicht. Vorzugsweise handelt es sich bei der EUV-Strahlung reflektierenden Schicht um eine Mehrfachbeschichtung bzw. eine Multilayerbeschichtung, bevorzugt aus alternierenden Schichten von Mo und Si mit einer Mo-Schichtdicke von beispielsweise 2,8 nm und einer Si-Schichtdicke von beispielsweise 5 nm. Eine solche EUV-Strahlung reflektierende MoSi-Mehrfachbeschichtung umfasst vorzugsweise eine abschließende Si-Schicht mit einer Dicke von beispielsweise 4 nm, um die Oxidation von Mo zu verhindern, wenn die Beschichtung der Umgebungsatmosphäre ausgesetzt wird.

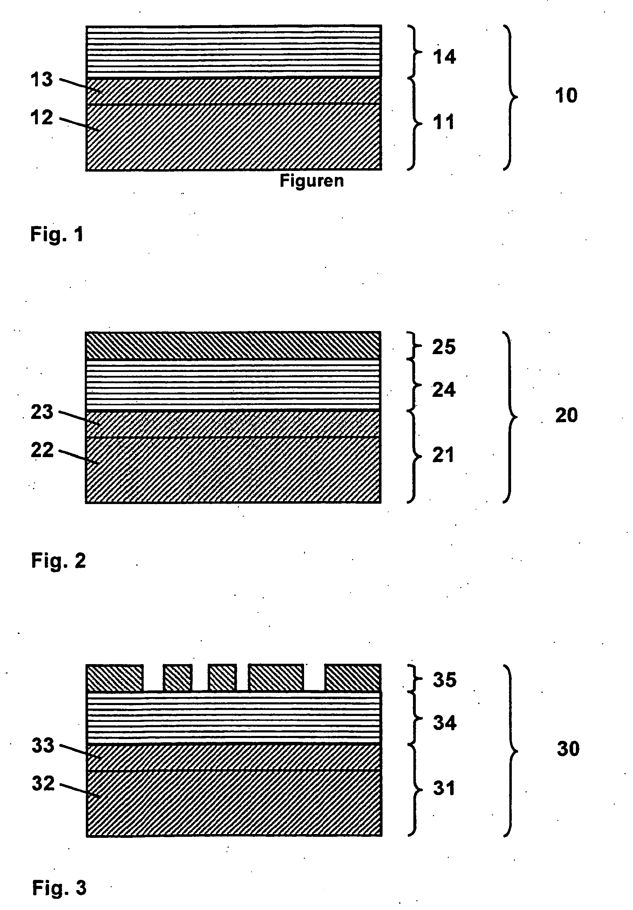

Mit dem erfindungsgemäßen Substrat können Spiegel für beispielsweise die Mikrolithographie, insbesondere die EUV-Lithographie, hergestellt werden, welche das erfindungsgemäße Substrat und eine reflektierende Beschichtung umfassen. Ein derartiger Spiegel kann sowohl eine ebene Oberfläche als auch eine gewölbte Oberfläche aufweisen. Um dem Spiegel eine gewölbte Oberfläche zu verleihen, kann bereits die Basisschicht des Substrats in der gewünschten Endform bereitgestellt werden. Anschließend werden die Deckschicht des Substrats und funktionelle Schichten, wie ggf. eine Haftschicht und eine reflektierende Schicht, beispielsweise wie vorstehend beschrieben, aufgebracht. Figur 1 zeigt einen schematischen Querschnitt durch eine Ausführungsform eines ebenen Spiegels 10. Auf dem zweischichtigen Substrat 11, umfassend Basisschicht 12 und Deckschicht 23, ist eine elektromagnetische Strahlung reflektierende Schicht 14 als funktionelle Schicht aufgetragen.

Zur Herstellung einer Maske bzw. eines Mask-Blanks für die EUV-Mikrolithographie wird die Oberfläche des erfindungsgemäßen Substrats mit einer EUV-Strahlung reflektierenden Schicht bzw. Beschichtung und mit einer EUV-Strahlung absorbierenden Schicht bzw. Beschichtung versehen. Die EUV-Strahlung absorbierende Schicht wird durch Lithographieverfahren strukturiert und so in eine Maske weiterverarbeitet. Eine solche EUV-Strahlung absorbierende Schicht umfasst vorzugsweise mindestens ein EUV-Strahlung absorbierende(s) Element bzw. Verbindung, wie beispielsweise Cr, Al, Ti, Ta oder dergleichen oder Verbindungen und/oder Mischungen davon.

Die vorliegende Erfindung betrifft somit auch eine Maske, welche das erfindungsgemäße Substrat und eine EUV-Strahlung reflektierende Oberfläche und eine EUV-Strahlung absorbierende Oberfläche umfasst. Erfindungsgemäß umfasst der Begriff "Maske" sowohl unstrukturierte Masken, sogenannte Mask-Blanks, als auch strukturierte Masken.

Eine Ausführungsform eines Mask-Blanks 20 ist schematisch in Figur 2 gezeigt. Auf dem zweischichtigen Substrat 21, umfassend Basisschicht 22 und Deckschicht 23, sind eine EUV-Strahlung reflektierende Schicht 24 und eine EUV-Strahlung absorbierende Schicht 25 aufgetragen.

Figur 3 zeigt schematisch den Querschnitt einer Ausführungsform einer strukturierten Maske 30, welche aus einem erfindungsgemäßen Mask-Blank hergestellt werden kann. Auf dem zweischichtigen Substrat 31, umfassend Basisschicht 32 und Deckschicht 33, sind eine EUV-Strahlung reflektierende Schicht 34 und eine EUV-Strahlung absorbierende Schicht 35 aufgetragen, wobei die absorbierende Schicht durch ein Lithographieverfahren strukturiert wurde. Eine solche EUV-Strahlung absorbierende Schicht kann EUV-Strahlen anbsorbierende Elemente wie Cr, Al, Ti, Ta oder dergleichen, sowie Gemische solcher Elemente umfassen.

Optische Elemente, wie Masken, Mask-Blanks und Spiegel für die Mikrolithographie, insbesondere die EUV-Lithographie, werden vorzugsweise durch Beschichten eines erfindungsgemäßen Substrats mit einer oder mehreren funktionellen Schichten mittels eines PVD oder Sputterverfahrens hergestellt.

### Beispiele

### Vergleichs- Beispiel 1

Eine Basisschicht aus Zerodur® (Ausdehnungsklasse 0, SCHOTT Glas, Mainz) mit einer Dicke von 5 mm und einer Oberflächenrauhigkeit von 0,1 nm rms wurde mittels eines PICVD-Verfahrens mit einer Deckschicht aus SiO₂ einer Stärke von 1,5 µm beschichtet. Die Deckschicht wurde anschließend auf eine Oberflächenrauhigkeit von 0,5 nm rms poliert.

Die Deckschicht haftete fest auf der Basisschicht an und zeigte auch nach Aufheiz- und Abkühlzyklen keine Risse. Durch eine anschließende IBF-Behandlung verschlechterte sich die Oberflächenrauhigkeit nicht.

### Beispiel 2

Eine Basisschicht aus Zerodur® (Ausdehnungsklasse 0, SCHOTT Glas, Mainz) mit einer Dicke von 5 mm und einer Oberflächenrauhigkeit von 0,1 nm rms wurde mittels eines Sputterverfahrens mit einer Deckschicht aus dotiertem SiO₂ (Sputtertarget: SiO₂ dotiert mit 7,5 Gew.-% TiO₂) einer Stärke von 1,5 µm beschichtet. Die Deckschicht wurde anschließend auf eine Oberflächenrauhigkeit von 0,5 nm rms poliert.

Die Deckschicht haftete fest auf der Basisschicht an und zeigte auch nach Aufheiz- und Abkühlzyklen keine Risse. Durch eine anschließende IBF-Behandlung verschlechterte sich die Oberflächenrauhigkeit nicht.

## Patentansprüche

1. Substrat für Präzisionselemente, umfassend mindestens eine Basisschicht und mindestens eine Deckschicht, wobei die Basisschicht einen thermischen Ausdehnungskoeffizienten von höchstens 10 ppb/°C aufweist **dadurch gekennzeichnet, dass** die Deckschicht einen thermischen Ausdehnungskoeffizienten von höchstens 1 ppm/°C aufweist, die Deckschicht SiO₂ welches mit TiO₂ dotiert ist,-umfasst und die Deckschicht eine Dicke von 0,01 bis 100 µm aufweist.

2. Substrat nach Anspruch 1, wobei die Basisschicht Keramik und/oder Glaskeramik umfasst.

3. Substrat nach Anspruch 1, wobei die Deckschicht andere Metalloxide, F und/oder ein Gemisch dieser Komponenten als Dotiermittel umfasst.

4. Substrat nach einem der vorangehenden Ansprüche,
wobei die Deckschicht eine Oberflächenrauhigkeit von höchstens 0,5 nm rms aufweist.

5. Verfahren zur Herstellung eines Substrats nach einem der Ansprüche 1 bis 4, umfassend die Schritte
(a) Bereitstellen einer Basisschicht, welche einen thermischen Ausdehnungskoeffizienten von höchstens 10 ppb/°C aufweist,
(b) Aufbringen einer Deckschicht, welche einen thermischen Ausdehnungskoeffizienten von höchstens 1,0 ppm/°C aufweist, und
(c) gegebenenfalls Polieren der Deckschicht.

6. Verfahren nach Anspruch 5, wobei die Deckschicht durch ein CVD-Verfahren, insbesondere ein PECVD-, PACVD oder PICVD-Verfahren aufgebracht wird und/oder wobei die Deckschicht durch ein IBF-Verfahren nachbehandelt wird.

7. Verfahren nach Anspruch 5 oder 6, wobei die Deckschicht in einer Schichtdicke von 0,01 µm bis 100 µm aufgebracht wird.

8. Verwendung eines Substrats nach einem der Ansprüche 1 bis 4 in der Mikrolithographie, der Astronomie oder der Messtechnik.

9. Maske, umfassend ein Substrat nach einem der Ansprüche 1 bis 4, eine EUV-Strahlung reflektierende Schicht und eine EUV-Strahlung absorbierende Schicht.

10. Spiegel, umfassend ein Substrat nach einem der Ansprüche 1 bis 4 und eine reflektierende Schicht.

## Claims

1. Substrate for precision elements, comprising at least one base layer and at least one covering layer, the base layer having a coefficient of thermal expansion of at most 10 ppb/°C, **characterized in that** the covering layer has a coefficient of thermal expansion of at most 1 ppm/°C, the covering layer comprises SiO₂, which is doped with TiO₂, and the covering layer has a thickness of 0.01 to 100µm.

2. Substrate according to Claim 1, in which the base layer comprises ceramic and/or glass-ceramic.

3. Substrate according to Claim 1, in which the covering layer comprises other metal oxides, F and/or a mixture of these components as dopants.

4. Substrate according to one of the preceding claims, in which the covering layer has a surface roughness of at most 0.5 nm rms.

5. Process for producing a substrate according to one of Claims 1 to 4, comprising the steps of
(a) providing a base layer which has a coefficient of thermal expansion of at most 10 ppb/°C,
(b) applying a covering layer which has a coefficient of thermal expansion of at most 1.0 ppm/°C, and
(c) if appropriate, polishing the covering layer.

6. Process according to Claim 5, in which the covering layer is applied by a CVD process, in particular a PECVD, PACVD or PICVD process and/or in which the covering layer is aftertreated by an IBF process.

7. Process according to Claim 5 or 6, in which the covering layer is applied in a layer thickness of 0.01 µm to 100 µm.

8. Use of a substrate according to one of Claims 1 to 4 in microlithography, astronomy or metrology.

9. Mask, comprising a substrate according to one of Claims 1 to 4, a layer which reflects EUV radiation and a layer which absorbs EUV radiation.

10. Mirror, comprising a substrate according to one of Claims 1 to 4 and a reflective layer.

## Revendications

1. Substrat pour éléments de précision comprenant au moins une couche de base et au moins une couche de couverture, la couche de base présentant un coefficient de dilatation thermique de 10 ppb/°C maximum, **caractérisé en ce que** la couche de couverture présente un coefficient de dilatation thermique de 1 ppm/°C maximum, la couche de couverture comprenant du SiO₂ qui est dopé au TiO₂ et la couche de couverture présentant une épaisseur de 0,01 à 100 µm.

2. Substrat selon la revendication 1, la couche de base comprenant de la céramique et/ou de la vitrocéramique.

3. Substrat selon la revendication 1, la couche de couverture comprenant d'autres oxydes métalliques, F et/ou un mélange de ces composants comme agent de dopage.

4. Substrat selon l'une des revendications précédentes, la couche de couverture présentant une rugosité de surface de 0,5 nm rms maximum.

5. Procédé de préparation d'un substrat selon l'une des revendications 1 à 4, comprenant les étapes suivantes :
a) fourniture d'une couche de base qui présente un coefficient de dilatation thermique de 10 ppb/°C maximum;
b) application d'une couche de couverture qui présente un coefficient de dilatation thermique de 1,0 ppm/°C maximum, et
c) éventuellement, polissage de la couche de couverture.

6. Procédé selon la revendication 5, la couche de couverture étant appliquée par un procédé CVD, en particulier un procédé PECVD, PACVD ou PICVD et/ou la couche de couverture subissant un traitement ultérieur par un procédé IBF.

7. Procédé selon l'une des revendications 5 ou 6, la couche de couverture étant appliquée sur une épaisseur de couche de 0,01 µm à 100 µm.

8. Utilisation d'un substrat selon l'une des revendications 1 à 4 en microlithographie, en astronomie ou en technique de mesure.

9. Masque comprenant un substrat selon l'une des revendications 1 à 4, une couche réfléchissant le rayonnement EUV et une couche absorbant le rayonnement EUV.

10. Miroir comprenant un substrat selon l'une des revendications 1 à 4 et une couche réfléchissante.
